(19) Europäisches Patentamt
European Patent Office
Office européen des brevets

(11) **EP 4 697 446 A1**

(12) **EUROPÄISCHE PATENTANMELDUNG**

(43) Veröffentlichungstag:
**18.02.2026 Patentblatt 2026/08**

(21) Anmeldenummer: **25189087.7**

(22) Anmeldetag: **11.07.2025**

(51) Internationale Patentklassifikation (IPC):
**H01M 10/42** (2006.01)   **H01M 10/44** (2006.01)
**G01R 27/02** (2006.01)

(52) Gemeinsame Patentklassifikation (CPC):
**H01M 10/4285; G01R 27/02; H01M 10/44**

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**GE KH LA MA MD TN**

(30) Priorität: **22.07.2024 DE 102024206832**

(71) Anmelder: **PowerCo SE
38239 Salzgitter (DE)**

(72) Erfinder:
• **Duan, Jian
38239 Salzgitter (DE)**
• **Huang, Fuxing
38239 Salzgitter (DE)**
• **Yan, Xiaobo
38239 Salzgitter (DE)**

(74) Vertreter: **FDST Patentanwälte
Nordostpark 16
90411 Nürnberg (DE)**

(54) **VERFAHREN ZUR BESTIMMUNG EINER LADEKAPAZITÄT EINER BATTERIE**

(57) Die Erfindung nennt ein Verfahren zur Bestimmung einer Kapazität (C) einer Batterie (1), wobei an einer ersten Mehrzahl an Elektrodenfolien (2) jeweils ein Identifikator (8) angebracht wird, wobei jeweils aus der ersten Mehrzahl an Elektrodenfolien (2) eine zweite Mehrzahl an Einzelelektroden (4s) derart erzeugt wird, dass eine jeweilige Einzelelektrode (4s) anhand des zugehörigen Identifikators (8) zumindest chargenweise identifizierbar ist, wobei für die zweite Mehrzahl an Einzelelektroden (4s) während ihrer Erzeugung jeweils geometrische Daten (dG) und/oder materialbezogene Daten (dM) und/oder prozessbezogene Daten (dP) erfasst werden, und der jeweiligen Einzelelektrode (4s) anhand des Identifikators (8) der zugehörigen Elektrodenfolie (2) zugeordnet werden, wobei für jede der besagten Einzelelektroden (4s) anhand der jeweiligen geometrische Daten (dG) und/oder materialbezogene Daten (dM) und/oder prozessbezogene Daten (dP) eine Einzelschicht-Kapazität (Cs) ermittelt wird, und wobei eine Kapazität (C) einer Batterie (1), welche anhand der zweiten Mehrzahl an Einzelelektroden (4s) gebildet wird, anhand der zugehörigen Einzelschicht-Kapazitäten (Cs) ermittelt wird.

Fig. 1

EP 4 697 446 A1

**Beschreibung**

Die Erfindung betrifft ein Verfahren zur Bestimmung einer Kapazität einer Batterie, insbesondere einer Batterie für ein Kraftfahrzeug (Kfz).

Bei der Produktion von Batterien, insbesondere von Lithium(Li)-Ionen-Batterien, ist eine korrekte Bestimmung der Kapazität der Batterie, also letzten Endes der Ladungs- und somit der Energiemenge, die der Batterie entnommen werden kann, von wesentlicher Bedeutung. Gerade für elektrische Kfz, in welchen eine möglichst hohe Volumenladungsdichte gewünscht wird, können diesbezüglich die üblichen Schwankungen, welche bei Produktionsprozessen auftreten, nicht vernachlässigt werden. Deshalb werden meist alle Batterien vom Hersteller vor Auslieferung nochmals hinsichtlich ihrer Kapazität getestet.

Um die Kapazität jeder einzelnen hergestellten Batterie zu testen, sind jedoch einerseits erhebliche Investitionen des Herstellers in entsprechende Prüfstände erforderlich, sowohl hinsichtlich der tatsächlichen Testanlagen, als auch des Platzbedarfes. Ein derartiger Test, bei welchem meist die Batterie (ggf. mehrfach) geladen und wieder entladen wird, während die aufgenommene und die abgegebene Ladungsmenge registriert werden, kann für jede einzelne Batterie mehrere Stunden dauern, was sich negativ auf die Kostenstruktur der Herstellung auswirkt.

Um das Testen der Kapazität hergestellter Batterien abzukürzen, existieren verschiedene Lösungsansätze. Ein solcher Lösungsansatz sieht vor, dass eine Batterie für den Test nicht mehr vollständig geladen und wieder entladen wird, sondern nur Teile dieses Prozesses durchgeführt werden, und z.B. auf das vollständige Entladen verzichtet wird, wobei die fehlenden Daten extrapoliert werden. Zu einer realen Zeitersparnis kommt man jedoch nur, wenn auch der Ladevorgang unter besagter Extrapolierung der nicht erhobenen Ergebnisse abgekürzt wird (etwa unter Messung zugehöriger Leerlaufspannungen o.ä.). Ein derartiges Vorgehen führt jedoch zunächst zu erheblichen Präzisionsverlusten bei der Bestimmung der Kapazität einer Batterie.

Entsprechend kann die Kapazität einer gelieferten Batterie (auch angesichts der auftretenden Schwankungen im Herstellungsprozess) nicht ausreichend gewährleistet werden. Als eine Verbesserung dieses Lösungsansatzes wird daher versucht, für eine Vielzahl an Batterien entsprechende Ladekurven des oben beschriebenen "partiellen" Ladeprozesses zu erheben, und hieraus ein auf künstlicher Intelligenz "Artificial Intelligence", AI) basierendes Modell zu erstellen, indem etwa die jeweils aus den Ladekurven der partiellen Ladeprozesse resultierenden Extrapolierungen für die Kapazität der Batterien durch einen Abgleich mit realen Messungen der Kapazität überprüft werden, und hieraus Trainingsdaten (mit zugehörigen Fehlerdaten) für das Modell gewonnen werden können.

Ein vergleichbarer Ansatz wird in der CN 114 660 462 A vorgeschlagen, die ein AI-basiertes Modell zur Prädiktion einer Batterieleistung nennt, für welche einzelne Informationen wie z.B. Spannung, Alterung ("State of Health"), Temperatur und weitere modellspezifische Informationen einer Vielzahl an Batterien erhoben werden, um das Modell zu trainieren. Anhand des Modells kann nun für eine Batterie eine verfügbare Batterieleistung aus ebendiesen Informationen der betreffenden Batterie ermittelt werden.

Ein Problem dieser AI-basierten Modelle, welche reale Information von Batterien verwenden (wie z.B. eine partielle Ladekurve oder Daten zu Temperatur und Spannung o.ä. beim Laden/Entladen), um daraus durch entsprechendes Training das Verhalten einer konkreten Batterie abschätzen zu können, ist die Anforderung einer meist sehr aufwändigen Trainingsphase, in welcher zudem die Kapazität sämtlicher Batterien auch tatsächlich gemessen werden muss, um etwa eine Fehlerrückführung des Modells zu ermöglichen.

Dies verringert einerseits die potentiellen Einsparungen an Zeit und Ressourcen und somit den potentiellen Nutzen des Modells erheblich. Andererseits ist selbst bei einem umfangreichen Training des Modells die hinreichende Präzision einer Vorhersage der Kapazität immer noch nicht sichergestellt, da ggf. die Modellparameter eine solche präzise Aussage ggf. im gewünschten Umfang aus intrinsischen Gründen gar nicht ermöglichen.

Der Erfindung liegt daher die Aufgabe zugrunde, ein möglichst präzises Verfahren zur Bestimmung einer Kapazität einer Batterie anzugeben, welches einen möglichst geringen Zeit- sowie Investitionsaufwand erfordern soll.

Die genannte Aufgabe wird erfindungsgemäß gelöst durch ein Verfahren zur Bestimmung einer Kapazität einer Batterie, insbesondere einer Li-Ionen-Batterie, wobei an einer ersten Mehrzahl an Elektrodenfolien jeweils ein Identifikator angebracht wird, wobei jeweils aus der ersten Mehrzahl an Elektrodenfolien eine zweite Mehrzahl an Einzelelektroden derart erzeugt wird, dass eine jeweilige Einzelelektrode anhand des zugehörigen Identifikators zumindest chargenweise identifizierbar ist, wobei für die zweite Mehrzahl an Einzelelektroden während ihrer Erzeugung jeweils geometrische Daten und/oder materialbezogene Daten und/oder prozessbezogene Daten erfasst werden, und der jeweiligen Einzelelektrode anhand des Identifikators der zugehörigen Elektrodenfolie zugeordnet werden, wobei für jede der besagten Einzelelektroden anhand der jeweiligen geometrische Daten und/oder materialbezogene Daten und/oder prozessbezogene Daten, insbesondere mittels eines ersten mathematischen Modells, eine Einzelschicht-Kapazität ermittelt wird, und wobei eine Kapazität einer Batterie, welche anhand der zweiten Mehrzahl an Einzelelektroden gebildet wird, anhand der zugehörigen Einzelschicht-Kapazitäten, insbesondere mittels eines zweiten mathematischen Modells, ermittelt wird. Vorteilhafte und teils für sich gesehen erfinderische Ausgestaltungen sind Gegenstand der Unteransprüche und der nachfolgenden Beschreibung.

Unter einer Elektrodenfolie ist hierbei insbesondere eine Folie umfasst, welche durch eine entsprechende Beschichtung insbesondere mit elektrochemisch aktivem Material und ggf. weitere Verarbeitungsschritte wie bspw. Walzen/Kalandern, Erhitzen und entsprechenden Zuschnitt zu einer Einzelelektrode, also einer einzelnen Kathoden- oder Anodenschicht verarbeitet wird. Die Bezeichnung Elektrodenfolie umfasst dabei einerseits das zu beschichtende Substrat, also eine Aluminiumfolie für eine Kathodenschicht bzw. eine Kupferfolie für eine Anodenschicht, aber auch das Substrat in seinen weiteren Verarbeitungsschritten bis hin zur abschließenden Herstellung der Einzelelektrode (also bspw. das beschichtete Substrat, das beschichtete und gewalzte Substrat usw.).

Eine Elektrodenfolie kann hierbei insbesondere gegeben sein als ein eindeutig identifizierbarer Abschnitt einer durchgehenden Folienrolle, sodass aufeinanderfolgende Abschnitte, welche jeweils unterschiedliche Identifikatoren aufweisen, als unterschiedliche Elektrodenfolien betrachtet werden können. Eine Elektrodenfolie kann jedoch auch durch ein entsprechend zugeschnittenes Stück Folie für die Herstellung von Einzelelektroden (Kathoden- oder Anodenschichten) gegeben sein.

Unter einer Erzeugung einer zweiten Mehrzahl an Einzelelektroden aus der ersten Mehrzahl an Elektrodenfolien ist insbesondere umfasst, dass die besagte erste Mehrzahl an Elektrodenfolien, welche also insbesondere gegeben sein können durch entsprechend zugeschnittene und jeweils mit einem Identifikator versehene Folienstücke oder durch einzelne anhand der jeweiligen Identifikatoren erkennbaren Abschnitte einer durchgehenden Folienrolle, in eine zweite Mehrzahl an Einzelelektroden verarbeitet wird. Hierbei kann aus einer Elektrodenfolie durch die an ihr durgeführten Verarbeitungsschritte jeweils genau eine Einzelelektrode erzeugt werden, d.h., jede Einzelelektrode weist ihren eigenen Identifikator auf, oder aus einer Elektrodenfolie wird eine vorzugsweise kleine bis überschaubare Mehrzahl an Einzelelektroden erzeugt, welche hier als eine "Charge" an Einzelelektroden bezeichnet sein soll. Im letztgenannten Fall kann bevorzugt über den jeweiligen Identifikator der betreffenden Elektrodenfolie die Zugehörigkeit einer Einzelelektrode zur betreffenden Charge erkannt werden, wodurch die Einzelelektrode chargenweise identifizierbar ist.

Unter einer Erfassung von geometrische Daten und/oder materialbezogene Daten und/oder prozessbezogene Daten für eine Einzelelektrode während ihrer Erzeugung ist insbesondere umfasst, dass die besagten Daten erhoben werden, indem entsprechende Messungen an der zugehörigen Elektrodenfolie während ihrer Verarbeitung zur Einzelelektrode durchgeführt werden, also während der einzelnen Verarbeitungsprozesse oder jeweils dazwischen. Für den Verarbeitungsprozess einer Beschichtung der Elektrodenfolie mit elektrochemisch aktivem Material (aus welchem die jeweilige elektrisch aktive Lage der Anoden- bzw. Kathodenschicht gebildet wird) kann dies zudem den Prozess einer Mischung der Komponenten der Beschichtung umfassen. Insbesondere können für die Erfassung besagter Daten auch Messungen von Prozessparametern durchgeführt werden (z.B. ein Abstand von Walzen für einen Walz- bzw. Kalandrierprozess, eine Temperatur eines Ofens zum Erhitzen von beschichteten Elektrodenfolien etc.).

Unter den geometrischen Daten einer Einzelelektrode sind hierbei insbesondere Daten zu ihrer Abmessung (also Länge und Breite) umfasst, jedoch auch Daten zur Geometrie ihrer Beschichtung mit aktivem Material, wie z.B. eine Stärke bzw. Dicke der Beschichtung, oder ggf. eine Beschichtungsrandbreite, welche insbesondere die Breite des Übergangs von beschichteter zu unbeschichteter Elektrodenfolie charakterisiert. Insbesondere können die besagten Daten, wenn sie ihrer Natur nach nur für eine Einzelelektrode erfasst werden (wie etwa die Abmessungen), im Fall einer chargenweisen Identifizierung der Einzelelektroden für die Zuordnung zur jeweiligen Charge gemittelt werden, oder es kann jeweils ein Maximal-, Minimal- oder Medianwert verwendet werden.

Unter den materialbezogenen Daten einer Einzelelektrode sind hierbei insbesondere Daten umfasst, welche das elektrochemisch aktive Material charakterisieren, mit welchem die Elektrodenfolge zur Herstellung einer Einzelelektrode beschichtet wird, also insbesondere eine volumen- oder massebezogene Dichte an Ladungsträgern, eine spezifische Kapazität o.ä.

Unter den prozessbezogenen Daten einer Einzelelektrode sind insbesondere Koeffizienten umfasst, welche von einzelnen Verarbeitungsprozessen abhängen, und welche insbesondere anhand von entsprechenden Simulationen oder eine (überschaubaren) Anzahl an vorausgehenden Messungen ermittelt werden können. Derartige Koeffizienten können etwa von einer Dichte nach einem Walz- oder Kalandrierprozess oder von einer Mischung der Beschichtung abhängen. Insbesondere geben diese Koeffizienten als prozessbezogene Daten einen Effekt des zugehörigen Prozesses auf die Kapazität der zugehörigen Einzelelektrode an, und insbesondere können die Koeffizienten jeweils Werte aus Intervallen von [0.85; 1.15], bevorzugt [0.9; 1.1], besonders bevorzugt [0.95; 1.05] einnehmen (wobei für unterschiedliche Koeffizienten unterschiedliche Intervalle als mögliche Wertebereiche gelten können).

Unter einer Einzelschicht-Kapazität ist insbesondere derjenige Beitrag zu verstehen, den eine Einzelelektrode (Kathoden- oder Anodenschicht) zur Kapazität der Batterie liefert, und/oder die Kapazität (also insbesondere maximal aufnehmbare bzw. abgebbare Menge an Ladungsträgern) der betreffenden Einzelelektrode.

Diese Einzelschicht-Kapazität wird nun für jede Einzelelektrode anhand der geometrischen, materialbezogenen und/oder prozessbezogenen Daten ermittelt, vorzugsweise anhand eines entsprechenden ersten mathematischen Modells, in welches die jeweiligen Daten eingehen, und welches ggf. noch weitere Schätzgrößen umfassen kann, die als externe Parameter bereitgestellt werden können, und welche ggf. in einem noch zu beschreibenden Optimierungsverfahren nach und nach angepasst werden können. Die besagten Daten, welche während der bzw. zwischen oder nach den einzelnen Verarbeitungsschritten der Elektrodenfolie erfasst worden sind, werden hierbei anhand des an der jeweiligen Elektrodenfolie angebrachten Identifikators (also bzw. einer überstehenden Folienlasche mit einem aufgedruckten Barcode und/oder QR-Code und/oder RFID-Tag) der zugehörigen Einzelelektrode zugeordnet, und somit die Verwendung der korrekten Werte der geometrischen, materialbezogenen und/oder prozessbezogenen für die Berechnung der jeweiligen Einzelschicht-Kapazität sichergestellt.

Anhand dieser Einzelschicht-Kapazitäten der Einzelelektroden, insbesondere anhand ihrer Summe, wird dann eine Kapazität der fertigen Batterie ermittelt, welche aus den besagten Einzelelektroden vorzugsweise mittels entsprechenden Stapelns derselben gefertigt wird. Bei der Fertigstellung der Batterie kann insbesondere noch eine Einspritzung eines flüssigen Elektrolyten in eine den Einzelelektroden-Stapel umschließende Hülle erfolgen. Für besagte Einspritzung kann hierbei ein weiterer Parameter bzw. Koeffizient erfasst werden, welcher im o.g. ersten mathematischen Modell der Einzelschicht-Kapazität berücksichtigt werden kann. Die Batterie kann jedoch auch als eine Festelektrolyt-Batterie gefertigt werden, wobei besagte Einspritzung entfällt, und somit auch keinerlei entsprechende Parameter im besagten ersten mathematischen Modell zu berücksichtigen sind.

Es wird hierbei aus vorteilhafte Weise der Umstand ausgenutzt, dass die Kapazität des aus den Einzelelektroden gebildeten Elektrodenstapels der Batterie im Wesentlichen, und ggf. bis auf einen Temperaturfaktor, linear in den Einzelschicht-Kapazitäten der Einzelelektroden ist. Zudem lassen sich die Einzelschicht-Kapazitäten mittels eines geeigneten ersten mathematischen Modells anhand von Größen bestimmen, welche im Produktionsprozess ohne wesentlichen Mehraufwand erfasst werden können.

Bevorzugt wird dabei die Kapazität der Batterie anhand einer Summe der jeweiligen Einzelschicht-Kapazitäten der zweiten Mehrzahl an Einzelelektroden ermittelt. Dies ist insbesondere infolge der Parallelschaltung der Einzelschicht-Kapazitäten durch entsprechende Strombahnen vorteilhaft, welche jeweils zu einem gemeinsamen Anoden- oder Kathodenanschluss der Batterie führen. Insbesondere kann hierbei noch ein zweites mathematisches Modell verwendet werden, welches zusätzlich zur Summe der jeweiligen Einzelschicht-Kapazitäten noch einen oder mehrere weitere Parameter verwendet, wie etwa einen Temperaturkoeffizienten, welcher insbesondere abhängig ist von der Anzahl der Einzelelektroden, und einen Wärmetransport der von den Einzelelektroden erzeugten Abwärme charakterisiert. Die besagte Abhängigkeit des Temperaturkoeffizienten von der Anzahl der Einzelelektroden kann insbesondere anhand von (einer überschaubaren Anzahl an) Messungen vorab ermittelt werden.

Günstigerweise werden als geometrische Daten eine Länge und eine Breite und/oder eine Beschichtungsstärke und/oder ein Randflächenkoeffizient erfasst, und/oder als materialbezogene Daten eine Aktivmaterialdichte und/oder eine materialspezifische Kapazität, und/oder als prozessbezogene Daten ein Mischungskoeffizient und/oder ein Walzdichtekoeffizient und/oder ein Feuchtigkeitskoeffizient und/oder eine Beschichtungsrandbreite.

Die Länge und die Breite der Einzelelektrode geben somit die Abmessung ihrer Fläche an, wobei in erster Näherung grundsätzlich (insbesondere bis auf Korrekturterme) eine lineare Abhängigkeit der Einzelschichtkapazität von der Fläche angenommen werden darf. Die Beschichtungsstärke gibt die Dicke der Beschichtung der Elektrodenfolie und somit der Einzelelektrode mit elektrochemisch aktivem Material an, wobei auch hier grundsätzlich bei ansonsten gleichen Parametern der Beschichtung (insbesondere bei identischer Mischung und Dichte/Pressung) eine lineare Abhängigkeit der Einzelschichtkapazität von der Dicke, also der Stärke der Beschichtung angenommen werden darf. Insbesondere kann jedoch die Beschichtungsstärke auch in der Aktivmaterialdichte als impliziter Wert enthalten sein, wenn die Aktivmaterialdichte auf eine Fläche (und nicht auf ein Volumen) bezogen wird. In diesem Fall muss die Beschichtungsstärke nicht gesondert gemessen werden. Ebenso gilt diese . Die genannten geometrischen Daten können hierbei bevorzugt in cm oder sonstigen Längeneinheiten angegeben werden.

Die Aktivmaterialdichte gibt bevorzugt an, welcher Masseanteil an elektrochemisch aktivem Material pro Flächeneinheit oder pro Volumeneinheit im der Beschichtung vorhanden ist, und geht somit bevorzugt auch linear in ein Modell der Einzelschichtkapazität ein. Die Aktivmaterialdichte kann dabei bevorzugt in $g/cm^2$ oder auch in $g/cm^3$ (oder jeweils äquivalenten Einheiten) angegeben werden. Die materialspezifische Kapazität gibt bevorzugt eine Kapazität bzw. Ladung des besagten aktiven Materials in der Beschichtung an, welche bspw. über unterschiedliche "Batches" von geliefertem bzw. bereitgestelltem aktiven Material variieren kann, und kann dabei in mAh/g ((oder äquivalenten Einheiten) angegeben werden. Die materialspezifische Kapazität geht somit bevorzugt ebenfalls linear in das Modell der Einzelschichtkapazität ein.

Die besagte Annahme der linearen Abhängigkeit der Einzelschichtkapazität gilt vorzugsweise auch für die Beschichtungsrandbreite, also für einen streifenförmigen Flächenbereich der Elektrodenfolie (und somit der Einzelelektrode), welcher den Übergang zwischen beschichteter und unbeschichteter Elektrodenfolie markiert.

Der Mischungskoeffizient kann bevorzugt einen Effekt der Mischung des elektrochemisch aktiven Materials mit weiteren, insbesondere prozessbedingten Beigaben wie Binder und/oder Lösemittel (aber auch leitfähiger Partikel), welche vor der Beschichtung beigemischt werden, auf die Kapazität angeben. Der Walzdichtekoeffizient kann bevorzugt einen Effekt beschreiben, welchen unterschiedliche Dichten als Resultat des Walzens und/oder Kalanderns auf die Einzelschichtkapazität haben. Der Randflächenkoeffizient beschreibt bevorzugt den Einfluss von Randeffekten der gestapelten Einzelelektroden auf die Kapazität der fertigen Batterie, welche abhängig vom Randflächenverhältnis sind (also vom Verhältnis der für die Randeffekte relevanten Randflächen zur Gesamtfläche der jeweiligen Einzelelektrode). Der Feuchtigkeitskoeffizient beschreibt bevorzugt den Einfluss der Raumfeuchte beim Produktionsprozess auf die Einzelschichtkapazität.

Die besagten Koeffizienten können hierbei insbesondere in einer Serie an Vorab-Einzelmessungen ermittelt werden, und/oder im Produktionsprozess iterativ angepasst werden, indem einzelne fertiggestellte Batterien stichprobenartig getestet werden, und jeweils das Testresultat mit dem anhand des ersten mathematischen Modells der Einzelschicht-Kapazitäten ermittelten Wert der Kapazität der betreffenden Batterie verglichen wird, und entsprechende Anpassungen an den genannten Koeffizienten vorgenommen werden. Der Mischungskoeffizient, der Randflächenkoeffizient, der Feuchtigkeitskoeffizient und der Walzdichtenkoeffizient können hierbei jeweils insbesondere Werte aus Intervallen von [0.85; 1.15], bevorzugt [0.9; 1.1], besonders bevorzugt [0.95; 1.05] einnehmen (wobei für unterschiedliche Koeffizienten unterschiedliche Intervalle als mögliche Wertebereiche gelten können).

Vorteilhafterweise werden für eine betreffenden Einzelelektrode die Länge und die Breite sowie insbesondere der Randflächenkoeffizient während eines Stapelprozesses von Einzelelektroden oder unmittelbar davor erfasst, und/oder die Beschichtungsstärke während eines Beschichtungsprozesses der Elektrodenfolie oder unmittelbar danach erfasst. Unter einer Erfassung einer bestimmten Messgröße unmittelbar vor (bzw. nach) einem bestimmten Verarbeitungsschritt der Elektrodenfolie ist dabei grundsätzlich insbesondere eine Erfassung vor (bzw. nach) dem betreffenden Verarbeitungsschritt, jedoch nach (bzw. vor) einem weiter vorangehenden (bzw. nachfolgenden) Verarbeitungsschritt zu verstehen. Unter der Beschichtungsprozess der Elektrodenfolie ist hierbei insbesondere das eigentliche Auftragen einer oder mehrerer Mischungen (und ggf. Hilfsmaterialien wie Lösemittel etc.) auf die Elektrodenfolie zu verstehen. Insbesondere kann die Beschichtungsstärke hierbei mittels einer Lasermessung bestimmt werden. Unter der Erfassung eines Koeffizienten ist hierbei insbesondere die Erfassung der dem Koeffizienten zugrunde liegenden Variablen (also geometrischen und/oder Prozessparameter) zu verstehen.

Als weiter vorteilhaft erweist es sich, wenn die materialspezifische Kapazität anhand einer Mischung von Komponenten für den Beschichtungsprozess bestimmt wird, und/oder die Aktivmaterialdichte während des Beschichtungsprozesses oder unmittelbar danach erfasst wird. Insbesondere kann hierbei die die materialspezifische Kapazität während einer Bereitstellung der Mischung für den Beschichtungsprozess anhand einzelner Volumen- und/oder Gewichtsanteile der dabei verwendeten Edukte bestimmt werden. Insbesondere kann die Aktivmaterialdichte mittels einer Absorptionsmessung, bspw. einer Absorptionsspektroskopie, ermittelt werden, welche bspw. die Absorption von Betastrahlung durch die Beschichtung misst.

In einer weiter vorteilhaften Ausgestaltung wird der Mischungskoeffizient anhand der Mischung von Komponenten für den Beschichtungsprozess bestimmt, und/oder die Beschichtungsrandbreite wird, insbesondere mittels Mikroskopie, während eines Beschichtungsprozesses der Elektrodenfolie oder unmittelbar danach erfasst, und/oder der Walzdichtekoeffizient wird während eines Walzprozesses der beschichteten Elektrodenfolie oder unmittelbar danach erfasst. Hierbei werden für die Erfassung der besagten Koeffizienten jeweils zum genannten Zeitpunkt (also beim/nach dem jeweiligen Verarbeitungsschritt) die zugehörigen physikalischen bzw. chemischen Variablen ermittelt, von welchen der betreffende Koeffizient jeweils abhängig ist. Die Abhängigkeit des jeweiligen Koeffizienten von den zugehörigen physikalischen bzw. chemischen Größen ist dabei bevorzugt bereits vorab in bereits beschriebener Weise ermittelt worden. Der Feuchtigkeitskoeffizient wird bevorzugt nach einem Ausdampfen der Binder, Lösemittel und sonstigen flüchtigen Bestandteile des Beschichtungsmaterials erfasst, vorzugsweise mittels einer Messung der Luftfeuchtigkeit in der die betreffende Produktionsanlage umgebenden Raumluft.

Zweckmäßigerweise wird die Batterie anhand der zweiten Mehrzahl an Einzelelektroden gebildet, wobei die zweite Mehrzahl an Einzelelektroden in einem Stapelprozesses zu einem Elektrodenstapel gestapelt wird, der Elektrodenstapel in einer Hülle eingeschlossen wird, und in die Hülle ein Elektrolyt injiziert wird, und wobei während des besagten Injizierens des Elektrolyten oder unmittelbar ein Elektrolyt-Inkjektionskoeffizient erfasst wird, welcher danach als weitere prozessbezogene Daten den betreffenden Einzelelektroden zugeordnet wird, oder welcher dem Elektrodenstapel zugeordnet wird. Dies umfasst insbesondere, dass die Einzelelektroden, also die einzelnen Anoden- und Kathodenschichten, abwechselnd gestapelt werden, sowie, dass der Einschluss dieses Stapels durch die Hülle noch einzelne Anoden- bzw. Kathodenkontakte zur entsprechenden Kontaktierung nicht einschließt.. Der Elektrolyt-Injektionskoeffizient beschreibt dabei bevorzugt Effekte des Elektrolyten bzw. der Feuchtigkeit auf die Kapazität, insbesondere die Einzelschicht-Kapazität, und kann insbesondere in bereits beschriebener Weise vorab durch entsprechende Einzelmessungen und/oder Modelle sowie durch ein kontinuierliches Optimieren der Modelle anhand realer Stichprobenmessungen bestimmt werden. Der Elektrolyt-Inkjektionskoeffizient kann dann als ein Faktor auf in das Modell der Einzelschichtkapazität eingehen, oder als gemeinsamer Faktor in die Kapazität der "vollständigen" Batterie eingehen (also bspw. "vor" einer Summe der besagten Einzelschichtkapazitäten).

Besonders bevorzugt wird dabei für die jeweilige Einzelelektrode die Einzelschicht-Kapazität Cs anhand einer linearen Relation der zugehörigen geometrischen Daten, also vorzugsweise der Länge x und der Breite y sowie des Randflächenkoeffizienten Ed und/oder der materialbezogenen Daten, also vorzugsweise der Aktivmaterialdichte md und der materialspezifischen Kapazität as, und/oder der prozessbezogenen Daten, also vorzugsweise der Beschichtungsrandbreite yr, des Mischungskoeffizienten Em, des Walzdichtekoeffizienten Er, des Feuchtigkeitskoeffizienten Eh und ggf. des Elektrolyt-Injektionskoeffizienten E-in ermittelt.

Die Einzelschicht-Kapazität Cs beträgt dann gemäß einem ersten mathematischen Modell bevorzugt

$$(i) \qquad Cs = Fc \cdot as \cdot md \cdot x \cdot (y - yr/2),$$

wobei der Koeffizientenfaktor Fc bevorzugt gebildet wird aus dem Produkt der beteiligten Koeffizienten, also insbesondere dem Mischungskoeffizienten Em, dem Walzdichtekoeffizienten Er, dem Randflächenkoeffizient Ed, dem Feuchtigkeitskoeffizienten Eh und ggf. dem Elektrolyt-Injektionskoeffizienten E-in als

$$Fc = Em \cdot Er \cdot Ed \cdot Eh \cdot E\text{-}in.$$

Die Kapazität der Batterie beträgt dann gemäß einem zweiten mathematischen Modell die Summe der Einzelschicht-Kapazitäten Cs, ggf. multipliziert mit einem Temperaturkoeffizienten Eth, welcher den Wärmetransport der Wärme durch die Einzelelektroden charakterisiert.

Bevorzugt wird jede Einzelelektrode der zweiten Mehrzahl aus einer eigenen Elektrodenfolie der ersten Mehrzahl erzeugt. Dies bedeutet insbesondere, dass jeder Einzelelektrode ein eigener Identifikator der zugehörigen Elektrodenfolie zugeordnet ist, wodurch die betreffenden Daten besonders präzise erfasst werden können, da insbesondere keine Interpolation bzw. Mittelung von Daten auf der Ebene der Elektrodenfolie für mehrere Einzelelektroden erforderlich ist.

Vorteilhafterweise wird als Identifikator ein QR-Code und/oder ein Barcode auf einer überstehenden Lasche an der Elektrodenfolie und/oder auf einer unbeschichtet verbleibenden Aussparung der Elektrodenfolie angebracht. Dieses Vorgehen ist prozesstechnisch einfach umzusetzen und gewährleistet eine hohe Sicherheit der Erkennung des jeweiligen Identifikators während der einzelnen Verarbeitungsschritte der zugehörigen Elektrodenfolie.

Die Erfindung nennt weiter ein Verfahren zur Optimierung einer Bestimmung einer Kapazität einer Batterie, wobei für eine Mehrzahl an Batterien eine Kapazität gemäß dem vorbeschriebenen Verfahren bestimmt wird, wobei für wenigstens eine dieser Batterien die Kapazität gemessen wird, und wobei anhand der gemessenen Kapazität wenigstens ein Parameter zur Bestimmung einer Einzelschicht-Kapazität der jeweiligen Einzelelektroden angepasst wird. Als Parameter kann hierbei insbesondere wenigstens einer der genannten Koeffizienten der prozessbezogenen Daten angepasst werden. Die Messung der Kapazität der Batterie umfasst hierbei insbesondere eine Messung anhand eines Lade- bzw. Entladevorgangs.

Die für das o.g. Verfahren zur Bestimmung der Kapazität und für dessen Weiterbildung vorgeschlagenen Vorteile können hierbei sinngemäß, mutatis mutandis, auf das Verfahren zu dessen Optimierung übertragen werden.

Nachfolgend wird ein Ausführungsbeispiel der Erfindung anhand von Zeichnungen näher erläutert. Hierbei zeigt schematisch:

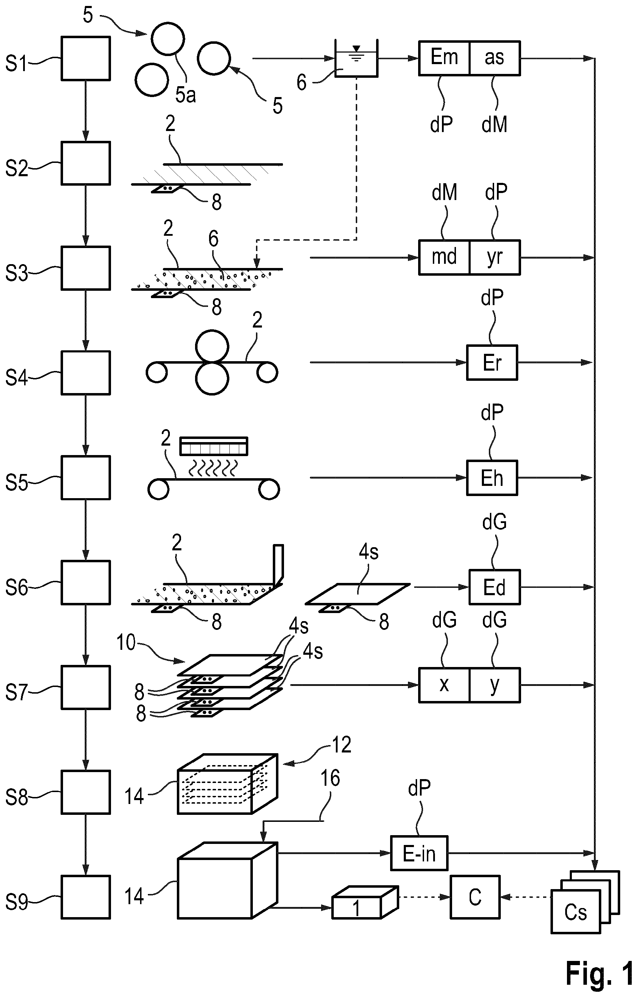

Fig. 1     in einem Flussdiagramm ein Verfahrens zur Bestimmung einer Kapazität einer Batterie anhand von Einzelschicht-Kapazitäten.

In Figur 1 ist in einem Flussdiagramm der Ablauf eines Verfahrens zur Bestimmung einer Kapazität C einer Batterie 1 dargestellt. Für die Herstellung der Batterie 1 werden hierbei zunächst eine erste Mehrzahl an Elektrodenfolien 2 zu einer zweiten Mehrzahl an Einzelelektroden 4s (Kathoden- und Anodenschichten) verarbeitet, und aus diesen die Batterie 1 gebildet. Für die Bestimmung der Kapazität C der Batterie 1 werden hierbei während der verschiedenen Verarbeitungsschritte S1-S9 geometrische Daten dG, materialbezogene Daten dM und prozessbezogene Daten dP erfasst, anhand derer in noch zu beschreibender Weise für die Einzelelektroden 4s jeweilige Einzelschicht-Kapazitäten Cs ermittelt werden. Aus den Einzelschicht-Kapazitäten Cs wird letztendlich die Kapazität C der fertigen Batterie 1 bestimmt.

In einem ersten Verarbeitungsschritt S1 wird aus verschiedenen Edukten 5, welche ein elektrochemisch aktives Material 5a umfassen , eine Mischung 6 bereitgestellt. Für die Fertigung von Kathodenschichten als Einzelelektroden 4s kann hierbei insbesondere NCM, LFP, LMFP, NCA, LMO oder Mischungen der genannten Materialien als elektrochemisch aktives Material 5a verwendet werden, für die Fertigung von Anodenschichten als Einzelelektroden 4s kann insbesondere Graphit, Kohlenstoff, Silizium, eine Mischung aus Silizium und Kohlenstoff, und/oder metallisches Lithium als elektrochemisch aktives Material 5a verwendet werden. Hierbei kann aus der Zusammensetzung der Mischung als materialbezogene Daten dM bereits eine materialspezifische Kapazität as und ggf. ein Mischungskoeffizient Em als prozessbezogene Daten dP gewonnen werden. Die materialspezifische Kapazität as beschreibt hierbei insbesondere die Kapazität und/oder Ladungsträgerdichte des elektrochemisch aktiven Materials 5a der Beschichtung pro Gewichtseinheit, während der Mischungskoeffizient Em insbesondere die Einflüsse von prozessbedingten Beigaben zum elektrochemischen Material (wie etwa Binder und/oder Lösemittel) auf die Einzelschichtkapazität Cs charakterisiert.

In einem nächsten Verarbeitungsschritt S2 wird die Elektrodenfolie 2 (also bspw. eine Kupferfolie für die Anodenschichten und bspw. eine Aluminiumfolie für die Kathodenschichten) bereitgestellt, und jeweils mit einem Identifikator 8 versehen (bspw. einer Lasche mit einem QR-Code), wobei in bereits beschriebener Weise jeder Identifikator 8 einer einzelnen Elektrodenfolie 2 zugeordnet ist (und eine zusammenhängende Elektrodenfolie 2 anhand ihrer unterschiedlichen Identifikatoren 8 als unterschiedliche Stücke der Elektrodenfolie 2 aufgefasst werden).

Im nächsten Verarbeitungsschritt S3 wird die jeweilige Elektrodenfolie 2 mit der Mischung 6 beschichtet, wobei eine Aktivmaterialdichte md (als materialbezogene Daten dM) und eine Beschichtungsrandbreite yr (als prozessbezogene Daten dP) in bereits beschriebener Weise erfasst werden, die gemeinsam mit der materialspezifischen Kapazität as und dem Mischungskoeffizienten Em der Mischung 6 anhand des Identifikators 8 eindeutig der Elektrodenfolie 2 (also insbesondere dem mit dem Identifikator 8 versehenen Stück) zugeordnet werden können.

Im nachfolgenden Verarbeitungsschritt S4 wird die beschichtete Elektrodenfolie 2 gewalzt und/oder kalandert, wobei eine Dichte der Beschichtung erfasst wird, und anhand dieser als prozessbezogene Daten dM ein Walzdichtekoeffizient Er erfasst wird, welcher ebenfalls anhand des Identifikators 8 eindeutig der Elektrodenfolie 2 zugeordnet werden können. Nach dem Walzen in Verarbeitungsschritt S4 erfolgt im Verarbeitungsschritt S5 ein Erhitzen ("Baking") der beschichteten und gewalzten Elektrodenfolie zum Ausheizen von Lösemitteln in der Beschichtung der Mischung 6 (sowie im hier nicht dargestellten Fall eines Festelektrolyten zum Sintern). Hierbei kann anhand einer Luftfeuchtigkeit der Umgebungsluft im Prozess zudem als weitere prozessbezogene Daten dP ein Feuchtigkeitskoeffizient Eh ermittelt werden.

Im darauffolgenden Verarbeitungsschritt S6 wird die Elektrodenfolie 2 zugeschnitten, und hierbei die Einzelelektroden 4s gebildet. Beim Zuschnitt können Parameter erfasst werden, anhand derer als geometrische Daten dG ein Randflächenkoeffizient Ed ermittelt wird. Weiter können unmittelbar nach dem Zuschnitt in Verarbeitungsschritt S6, oder während eines danach folgenden Stapelns in einem Verarbeitungsschritt S7 als geometrische Daten dG die Abmessungen, also die Länge x und die Breite y der Einzelelektroden 4s erfasst werden. Auch der Randflächenkoeffizient Ed und die Länge x und Breite y können anhand des Identifikators 8 eindeutig der Elektrodenfolie 2 zugeordnet werden.

Nach besagtem Stapeln der Einzelelektroden 4s zu einem Elektrodenstapel 10 im besagten Verarbeitungsschritt S7 wird letzterer in einem darauffolgenden Verarbeitungsschritt S8 zu einer Batteriezelle 12 verarbeitet, und hierbei insbesondere von einer Hülle 14 umschlossen. In einem nachfolgenden Verarbeitungsschritt S9 wird ein Elektrolyt 16 für die Batterie 1 in die Hülle 14 injiziert, wobei Parameter für einen Elektrolyt-Injektionskoeffizienten E-in (als prozessbezogene Daten dP) erfasst werden. Die Hülle 14 wird anschließend verschlossen, und die letzten Fertigungsschritte (nicht näher dargestellt) werden durchgeführt, um die Fertigung der Batterie 1 abzuschließen.

Anhand der besagten, jeweils über den zugehörigen Identifikator 8 zugeordneten geometrischen Daten dG (as, md), der materialbezogenen Daten dM (x, y, yr) und der Prozessbezogenen Daten dP (Ed, Em, Er, E-in) wird nun für jede Einzelelektrode 4s gemäß Gleichung (i) die Einzelschicht-Kapazität Cs berechnet zu

$$(i) \qquad Cs = Fc \cdot as \cdot md \cdot x \cdot (y - yr/2)$$

mit $Fc = Em \cdot Er \cdot Eh \cdot Ed \cdot E\text{-}in$. Die Kapazität C der Batterie ergibt sich dann als die Summe über die Einzelschicht-Kapazitäten Cs.

Bevorzugt können vereinzelt die jeweiligen Kapazitäten von Exemplaren der wie beschrieben gefertigten Batterie 1 getestet werden (also etwa durch ein Laden/Entladen), und die Resultate jeweils mit denjenigen nach Gleichung (i) verglichen werden, um die Bestimmung nach Gleichung (i) zu optimieren, und insbesondere die Koeffizienten des Koeffizientenfaktors Fc anzupassen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Bezugszeichenliste**

| 1 | Batterie |
|---|---|
| 2 | Elektrodenfolie |
| 4s | Einzelelektroden |
| 5 | Edukte |
| 5a | elektrochemisch aktives Material |
| 6 | Mischung |
| 8 | Identifikator |

10   Elektrodenstapel
12   Batteriezelle
14   Hülle
16   Elektrolyt

as      materialspezifische Kapazität
C       Kapazität
Cs      Einzelschicht-Kapazität
dG      geometrische Daten
dM      materialbezogene Daten
dP      prozessbezogene Daten
Ed      Randflächenkoeffizient
Eh      Feuchtigkeitskoeffizient
Em      Mischungskoeffizient
Er      Walzdichtekoeffizient
E-in    Elektrolyt-Injektionskoeffizient
md      Aktivmaterialdichte
S1-S9   Verarbeitungsschritte
x       Länge
y       Breite
yr      Beschichtungsrandbreite

## Patentansprüche

1.   Verfahren zur Bestimmung einer Kapazität (C) einer Batterie (1),

  - wobei an einer ersten Mehrzahl an Elektrodenfolien (2) jeweils ein Identifikator (8) angebracht wird,
  - wobei jeweils aus der ersten Mehrzahl an Elektrodenfolien (2) eine zweite Mehrzahl an Einzelelektroden (4s) derart erzeugt wird, dass eine jeweilige Einzelelektrode (4s) anhand des zugehörigen Identifikators (8) zumindest chargenweise identifizierbar ist,
  - wobei für die zweite Mehrzahl an Einzelelektroden (4s) während ihrer Erzeugung jeweils geometrische Daten (dG) und/oder materialbezogene Daten (dM) und/oder prozessbezogene Daten (dP) erfasst werden, und der jeweiligen Einzelelektrode (4s) anhand des Identifikators (8) der zugehörigen Elektrodenfolie (2) zugeordnet werden,
  - wobei für jede der besagten Einzelelektroden (4s) anhand der jeweiligen geometrische Daten (dG) und/oder materialbezogene Daten (dM) und/oder prozessbezogene Daten (dP) eine Einzelschicht-Kapazität (Cs) ermittelt wird, und
  - wobei eine Kapazität (C) einer Batterie (1), welche anhand der zweiten Mehrzahl an Einzelelektroden (4s) gebildet wird, anhand der zugehörigen Einzelschicht-Kapazitäten (Cs) ermittelt wird.

2.   Verfahren nach Anspruch 1,
     wobei die Kapazität (C) der Batterie (1) anhand einer Summe der jeweiligen Einzelschicht-Kapazitäten (Cs) der zweiten Mehrzahl an Einzelelektroden (4s) ermittelt wird.

3.   Verfahren nach Anspruch 1 oder Anspruch 2,

  - wobei als geometrische Daten (dG) eine Länge (x) und eine Breite (y) und/oder eine Beschichtungsstärke und/oder ein Randflächenkoeffizient (Ed) erfasst werden, und/oder
  - wobei als materialbezogene Daten (dM) eine Aktivmaterialdichte (md) und/oder eine materialspezifische Kapazität (as) erfasst werden, und/oder
  - wobei als prozessbezogene Daten (dP) ein Mischungskoeffizient (Em) und/oder ein Walzdichtekoeffizient (Er) und/oder eine Beschichtungsrandbreite (yr) und/oder ein Feuchtigkeitskoeffizient (Eh) erfasst werden.

4.   Verfahren nach Anspruch 3,
     wobei für eine betreffenden Einzelelektrode (4s)

  - die Länge (x) und die Breite (y) und/oder der Randflächenkoeffizient (Ed) während eines Stapelprozesses (S7) von Einzelelektroden (4s) oder unmittelbar davor erfasst werden, und/oder
  - die Beschichtungsstärke während eines Beschichtungsprozesses (S3) der Elektrodenfolie oder unmittelbar danach erfasst wird.

5.   Verfahren nach Anspruch 3 oder Anspruch 4,
     wobei für eine betreffenden Einzelelektrode (4s)

  - die materialspezifische Kapazität (as) anhand einer Mischung (6) von Komponenten für den Beschichtungsprozess (S3) bestimmt wird, und/oder
  - die Aktivmaterialdichte (md) während des Beschichtungsprozesses (S3) oder unmittelbar danach erfasst wird.

6.   Verfahren nach einem der Ansprüche 3 bis 5,
     wobei für eine betreffenden Einzelelektrode (4s)

  - der Mischungskoeffizient (Em) anhand der Mischung (6) von Komponenten für den Beschichtungsprozess (S3) bestimmt wird, und/oder
  - die Beschichtungsrandbreite (yr) während eines Beschichtungsprozesses (S3) der Elektrodenfolie oder unmittelbar danach erfasst wird, und/oder
  - der Walzdichtekoeffizient (Er) während eines Walzprozesses (S4) der beschichteten Elektrodenfolie (2) oder unmittelbar danach erfasst wird.

**7.** Verfahren nach einem der vorhergehenden Ansprüche,

wobei die Batterie (1) anhand der zweiten Mehrzahl an Einzelelektroden (4s) gebildet wird, und hierbei

- die zweite Mehrzahl an Einzelelektroden (4s) in einem Stapelprozesses (S7) zu einem Elektrodenstapel (10) gestapelt wird,
- der Elektrodenstapel (10) in einer Hülle (14) eingeschlossen wird, und
- in die Hülle (14) ein Elektrolyt (16) injiziert wird,

wobei während des besagten Injizierens des Elektrolyten (16) oder unmittelbar danach als ein Elektrolyt-Inkjektionskoeffizient (E-in) erfasst wird, welcher weitere prozessbezogene Daten (dP) den betreffenden Einzelelektroden (4s) zugeordnet wird, oder welcher dem Elektrodenstapel (10) zugeordnet wird.

**8.** Verfahren nach einem der vorhergehenden Ansprüche,
wobei für die jeweilige Einzelelektrode (4s) die Einzelschicht-Kapazität (Cs) anhand einer linearen Relation der zugehörigen geometrische Daten (dG) und/oder materialbezogene Daten (dM) und/oder prozessbezogene Daten (dP) ermittelt wird.

**9.** Verfahren nach einem der vorhergehenden Ansprüche,
wobei jede Einzelelektrode (4s) der zweiten Mehrzahl aus einer eigenen Elektrodenfolie (2) der ersten Mehrzahl erzeugt wird.

**10.** Verfahren nach einem der vorhergehenden Ansprüche,
wobei als Identifikator (8) ein QR-Code und/oder ein Barcode auf einer überstehenden Lasche an der Elektrodenfolie (2) und/oder auf einer unbeschichtet verbleibenden Aussparung der Elektrodenfolie (2) angebracht wird.

**11.** Verfahren zur Optimierung einer Bestimmung einer Kapazität (C) einer Batterie (1), wobei für eine Mehrzahl an Batterien (1) eine Kapazität gemäß dem Verfahren nach einem der vorhergehenden Ansprüche bestimmt wird,
wobei für wenigstens eine dieser Batterien (1) die Kapazität (C) gemessen wird, und wobei anhand der gemessenen Kapazität (C) wenigstens ein Parameter zur Bestimmung einer Einzelschicht-Kapazität (Cs) der jeweiligen Einzelelektroden (4s) angepasst wird.

Fig. 1

Europäisches
Patentamt

European
Patent Office

Office européen
des brevets

# EUROPÄISCHER RECHERCHENBERICHT

Nummer der Anmeldung

EP 25 18 9087

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2009/024355 A1 (FACHHOCHSCHULE STRALSUND [DE]; HARZFELD EDGAR [DE]) 26. Februar 2009 (2009-02-26) * Ansprüche 1-17 * * das ganze Dokument * * Abbildung 4a *<br>----- | 1-11 | INV.<br>H01M10/42<br>H01M10/44<br>G01R27/02 |

**RECHERCHIERTE SACHGEBIETE (IPC)**

H01M
G01R

Der vorliegende Recherchenbericht wurde für alle Patentansprüche erstellt

| Recherchenort | Abschlußdatum der Recherche | Prüfer |
|---|---|---|
| München | 9. Dezember 2025 | Riederer, Florian |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
.........................................................................
& : Mitglied der gleichen Patentfamilie, übereinstimmendes
    Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.** EP 25 18 9087

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

09-12-2025

| Im Recherchenbericht angeführtes Patentdokument | Datum der Veröffentlichung | Mitglied(er) der Patentfamilie | Datum der Veröffentlichung |
|---|---|---|---|
| WO 2009024355 A1 | 26-02-2009 | DE 102007039941 A1<br>EP 2191257 A1<br>WO 2009024355 A1 | 26-02-2009<br>02-06-2010<br>26-02-2009 |

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 114660462 A